# EUROPÄISCHE PATENTSCHRIFT

(11) **EP 2 199 750 B1**
(45) Veröffentlichungstag und Bekanntmachung des Hinweises auf die Patenterteilung: **22.08.2018**
(21) Anmeldenummer: 09015629.0
(22) Anmeldetag: 17.12.2009
(51) Int. Cl.: G01D 4/00, G01R 11/04, H05K 5/02, H05K 7/14

(54) **Zusatzgerät für eine Stromzähleranschlussinstallation, insbesondere für eine Kommunikation mit dem Stromzähler**
Add-on device for a electricity meter add-on installation, in particular for communication with the electricity meter
Appareil supplémentaire pour une installation de raccordement de compteur électrique, notamment pour une communication avec le compteur électrique

(30) Priorität: 19.12.2008 DE 102008063878; 21.03.2009 DE 202009004362 U
(43) Veröffentlichungstag der Anmeldung: 23.06.2010
(73) Patentinhaber: Hager Electro GmbH & Co. KG, 66131 Saarbrücken (DE)
(72) Erfinder: Hauck, Johannes, 66440 Blieskastel (DE); Braun, Jeannette, 66399 Mandelbachtal (DE)
(74) Vertreter: Nuss, Laurent

(56) Entgegenhaltungen:
- EP-A2- 1 593 977
- EP-A2- 1 593 978
- DE-A1-102004 040 916
- DE-U1-202007 017 510
- GB-A- 2 272 530

## Beschreibung

Die Erfindung betrifft ein Zusatzgerät für eine Stromzähleranschlussinstallation, das separat von einem Stromzähler an die Stromzähleranschlussinstallation anschliessbar ist, insbesondere zur Kommunikation mit dem Stromzähler, wobei das Zusatzgerät Anschlüsse für Leitungen zur Stromversorgung und Signalübertragung aufweist.

Heute zunehmend zum Einsatz kommende elektronische Stromzähler können über ihre Zählfunktion hinaus weitere Funktionen übernehmen und insbesondere zur Kommunikation mit dem Stromversorgungsunternehmen, z.B. zwecks Fernablesung, Tarifumstellung oder dergleichen, verbindbar sein. Entsprechend sind Zusatzgeräte erforderlich, über welche eine solche Kommunikation erfolgt.

Aus der DE 10 2004 040 916 A1 ist ein Zusatzgerät für einen Stromzähler bekannt, das direkt in einen an dem Stromzähler gebildeten Aufnahmeraum einsetzbar und elektrisch mit dem Stromzähler verbindbar ist. Die Spannungsversorgung des Zusatzgeräts erfolgt über den Stromzähler.

Der Erfindung liegt die Aufgabe zugrunde, ein insbesondere für eine Kommunikation geeignetes Zusatzgerät der eingangs genannten Art zu schaffen, das den in Stromzählerinstallationen bestehenden Anforderungen in besonderem Maße gerecht wird.

Das diese Aufgabe lösende Zusatzgerät nach der Erfindung ist dadurch gekennzeichnet, dass es mehrteilig mit einem die Leitungsanschlüsse umfassenden Trägermodul und einem unter Herstellung von Verbindungen zu den Leitungsanschlüssen mit dem Trägermodul mechanisch verbindbaren Hauptfunktionsmodul ausgebildet ist.

Die Anschlussinstallation kann weitgehend vorgefertigt sein, indem der Trägermodul des Zusatzgerätes bereits installiert ist. Vorteilhaft kann nachträglich einer von mehreren mit dem Trögermodul verbindbaren Hauptfunktionsmodule entsprechend speziellen Anforderungen, insbesondere des Nutzers der Anschlussinstallation, ausgewählt werden. Auch ein späterer Austausch ist leicht möglich.

In einer bevorzugten Ausführungsform der Erfindung weist der Trägermodul eine bei Verbindung mit dem Hauptfunktionsmodul zu entfernende, den Zugang zu Verbindungskontakten zu den Anschlüssen versperrende Abdeckung auf. Bei nicht installiertem Hauptfunktionsmodul sind daher über die Verbindungskontakte weder Manipulationen am Stromzähler noch die Entnahme ungezählten Stroms möglich.

Zweckmäßig ist die Abdeckung nur durch Zerstörung der Abdeckung selbst oder/und einer Plombierung von dem Trägermodul entfernbar. So lassen sich Manipulationen nachweisen. Zum Beispiel kann eine Sollbruchstelle zum Ausbrechen der Abdeckung vorgesehen sein.

In der bevorzugten Ausführungsform der Erfindung umgibt der Trägermodul den Hauptfunktionsmodul in der Art einer Umrahmung. Zweckmäßig bildet diese Umrahmung einen Aufnahmeschacht für den Hauptfunktionsmodul.

Das Gehäuse des Hauptfunktionsmoduls weist zweckmäßig einen den Innenrand der Umrahmung übergreifenden Flanschansatz auf, die einen Zugang zu den Anschlusskontakten durch Unbefugte sicher verhindert.

Der Hauptfunktionsmodul kann in der Umrahmung einrastbar und ggf. in seiner Einrastposition plombierbar sein.

In der bevorzugten Ausführungsform der Erfindung ist die Anschlussinstallation zur Aufnahme eines elektronischen Stromzählers vorgesehen und zur Befestigung als komplette Baugruppe an einem Zählerplatz eines herkömmlichen elektro-mechanischen Stromzählers, insbesondere an dessen Zählerkreuz, vorgesehen.

Bei dem Zusatzgerät handelt es sich insbesondere um eine Kommunikationsgerät, insbesondere zur Fernübertragung von Daten zwischen der Stromzählanlage und einer Kommunikationseinrichtung, wobei das Kommunikationsgerät in weiterer Ausgestaltung der Erfindung über eine zum Anschluss eines Stromzählers vorgesehene Anschlusseinrichtung mit der Stromzählanlage verbindbar ist und ferner einen die Anschlüsse aufweisenden Trägermodul und einen unter Herstellung von elektrischen Verbindungen zu den Anschlüssen mit dem Trägermodul mechanisch verbindbaren Hauptfunktionsmodul umfasst.

Das Kommunikationsgerät, dem selbst keine Zählfunktion zukommt, kann zusammen mit wenigstens einem Stromzähler in einem mehrere Anschlusseinrichtungen für einen Stromzähler aufweisenden Stromzählanlage eingebaut werden, wobei der Einbau des Kommunikationsgerätes die gleichen Arbeitsgänge wie die Zählerinstallation erfordert. Vorteilhaft kann nachträglich einer von mehreren mit dem Trägermodul verbindbaren Hauptfunktionsmodule entsprechend speziellen Anforderungen, insbesondere des Nutzers der Anschlussinstallation, ausgewählt werden. Auch ein späterer Austausch ist leicht möglich. Ein an einen Anschlussplatz für einen Stromzähler anschließbares Zusatzgerät ist in der hier einbezogenen Patentanmeldung 10 2009 009 564.0 beschrieben, auf dessen Offenbarung hier voll umfänglich verwiesen wird.

Das Zusatzgerät bzw. Kommunikationsgerät und der Stromzähler können übereinstimmende Mittel zur Verbindung des Kommunikationsgerätes bzw. Stromzählers mit der Stromzählanlage über die Anschlusseinrichtung aufweisen.

Bei dem Stromzähler handelt es sich vorzugsweise um einen elektronischen Stromzähler mit Kontaktelementen zur elektrischen Verbindung des Stromzählers mit Phasenleitern und dem Neutralleiter.

Zweckmäßig ist das Zusatzgerät bzw. Kommunikationsgerät elektrisch mit wenigstens einem zu der Anschlusseinrichtung hinführenden Phasenleiter und dem Neutralleiter verbindbar.

Vorzugsweise ist das Kommunikationsgerät zur Datenübertragung über die mit der Anschlusseinrichtung verbundenen Stromleitungen vorgesehen.

In weiterer Ausgestaltung der Erfindung weisen das Kommunikationsgerät und der Stromzähler wenigstens anschlussseitig übereinstimmend ausgebildete Gehäuse auf.

Von dem Gehäuse können Hakenfüße und Kontaktelemente für den Eingriff in Öffnungsschlitze in einer Tragplatte der Stromzähleranschlusseinrichtung vorstehen.

In weiterer Ausgestaltung der Erfindung ist das Kommunikationsgerät in der Verbindungsposition mit der Stromzählanlage arretier- und plombierbar, vorzugsweise in gleicher Weise wie der Stromzähler.

Vorzugsweise ist das Kommunikationsgerät zur Datenfernübertragung zwischen mehreren Stromzählern und der genannten Kommunikationseinrichtung vorgesehen.

Insbesondere ist das Kommunikationsgerät zur Datenfernübertragung über das Telefonfestnetz, ein zellulares Funknetz oder/und ein GPRS-Datennetz vorgesehen.

Das Zusatzgerät bzw. Kommunikationsgerät kann in Funkverbindung mit mehreren Stromzählern der Stromzählanlage stehen. In weiterer Ausgestaltung der Erfindung weist der Trägermodul eine bei Verbindung mit dem Hauptfunktionsmodul zu entfernende, den Zugang zu Verbindungskontakten zu den Anschlüssen versperrende Abdeckung auf.

Die Abdeckung ist zweckmäßig ist nur durch Zerstörung der Abdeckung selbst oder/und einer Plombierung von dem Trägermodul entfernbar.

Zum Ausbrechen der Abdeckung kann eine Sollbruchstelle vorgesehen sein.

Zweckmäßig umgibt der Trägermodul den Hauptfunktionsmodul in der Art einer Umrahmung.

Vorzugsweise bildet die Umrahmung einen Einschubschacht für den Hauptfunktionsmodul.

Das Gehäuse des Hauptfunktionsmoduls kann einen den inneren Rand der Umrahmung umgreifenden Flanschansatz aufweisen.

Zweckmäßig ist der Hauptfunktionsmodul an dem Trägermodul einrastbar und ggf. in der eingerasteten Stellung plombierbar.

Das Zusatzgerät kann Bestandteil einer Anschlussinstallation für einen elektronischen Stromzähler sein, die als komplette Baugruppe an einem Zählerplatz eines herkömmlichen elektro-mechanischen Stromzählers, insbesondere an dessen Zählerkreuz, befestigt wird.

Die Erfindung wird nachfolgend anhand eines Ausführungsbeispiels und der beiliegenden, sich auf diese Ausführungsbeispiele beziehenden Zeichnungen weiter erläutert. Es zeigen:
- Fig. 1: eine Stromzähleranschlussinstallation mit einem Zusatzgerät nach der Erfindung,
- Fig. 2 und 3: das in der Anschlussinstallation von Fig. 1 verwendete Zusatzgerät in verschiedenen perspektivischen Ansichten,
- Fig. 4 und 5: das Zusatzgerät von Fig. 2 und 3 in verschiedenen perspektivischen Ansichten, wobei ein Trägerteil und Hauptfunktionsteil jeweils getrennt dargestellt sind,
- Fig. 6: das Zusatzgerät von Fig. 2 und 3 ohne Anschlussteile,
- Fig. 7: einen Trägermodul eines erfindungsgemäßen Zusatz- bzw. Kommunikationsgerätes,
- Fig. 8a: einen Hauptfunktionsmodul für das Kommunikationsgerät von Fig. 7 in isometrischer Darstellung,
- Fig. 8b: einen Aufnahmeschacht in isometrischer Darstellung, und
- Fig. 9: ein in den Aufnahmeschacht eingesetzter Hauptfunktionsmodul.

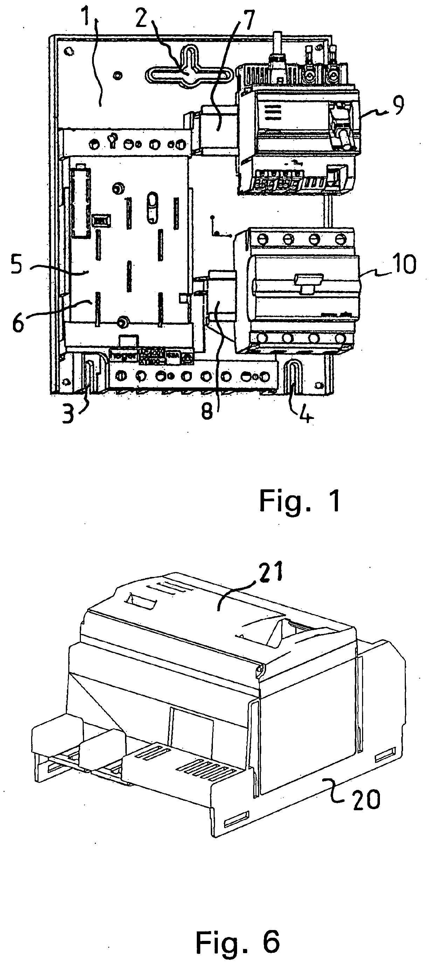

Eine in Fig. 1 gezeigte Anschlussinstallation für einen elektronischen Stromzähler weist eine Grundplatte 1 mit Befestigungsöffnungen 2 bis 4 zur Befestigung der Grundplatte am Zählerkreuz eines Zählerplatzes für einen herkömmlichen elektro-mechanischen Stromzähler auf. Der nicht gezeigte elektronische Stromzähler ist auf eine Tragplatte 5 aufsetzbar, wobei von dem Stromzähler vorstehende Anschlusskontakte durch Schlitze 6 in der Tragplatte hindurchtreten und bei Verschiebung des Stromzählers auf der Tragplatte mit hinter der Tragplatte angeordneten Anschlusskontakten in Verbindung kommen.

Auf der Grundplatte 1 sind Hutprofilträgerschienen 7 und 8 für die Aufnahme von Zusatzgeräten 9 und 10 vorgesehen. Bei dem Zusatzgerät 9 handelt es sich in dem gezeigten Beispiel um ein Kommunikationsgerät, über das sowohl das Stromversorgungsunternehmen als auch der Nutzer der Anschlussinstallation in Verbindung mit dem Stromzähler treten kann. Bei dem Zusatzgerät 10 handelt es sich um einen über das Zusatzgerät 9 ansteuerbaren Schalter, mit dessen Hilfe das Stromversorgungsunternehmen durch Fernbedienung den Versorgungsstromkreis unterbrechen und die Anschlussinstallation stilllegen kann.

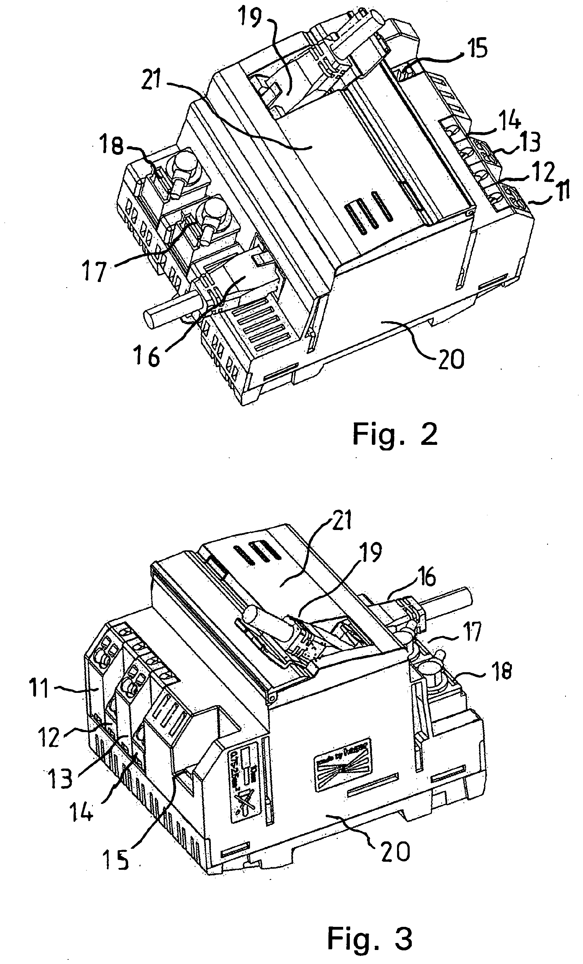

Das in den Figuren 2 bis 6 gesondert dargestellte Zusatzgerät 9 weist Anschlüsse 11 und 12 zur Stromversorgung auf, an die eine Phasenleitung sowie der Neutralleiter anzuschließen ist. Anschlüsse 13 und 14 dienen dem Anschluss mit dem Zusatzgerät bzw. Schalter 10 zu verbindender Steuerleitungen für die Stilllegung der Anschlussinstallation durch Fernauslösung. Über einen Anschluss 15 lässt sich eine Kommunikation zu dem Stromzähler herstellen. Anschlüsse 16 bis 18 dienen der Kommunikationsverbindung mit dem Stromversorgungsunternehmen, die über den Anschluss 16 per Telefonfestnetz und über die mit Antennen verbundenen Anschlüsse 17 und 18 per Telefonfunknetz erfolgen kann. Über einen Anschluss 19 schließlich hat der Nutzer Zugang zu dem Kommunikationsmodul und ggf. Stromzähler.

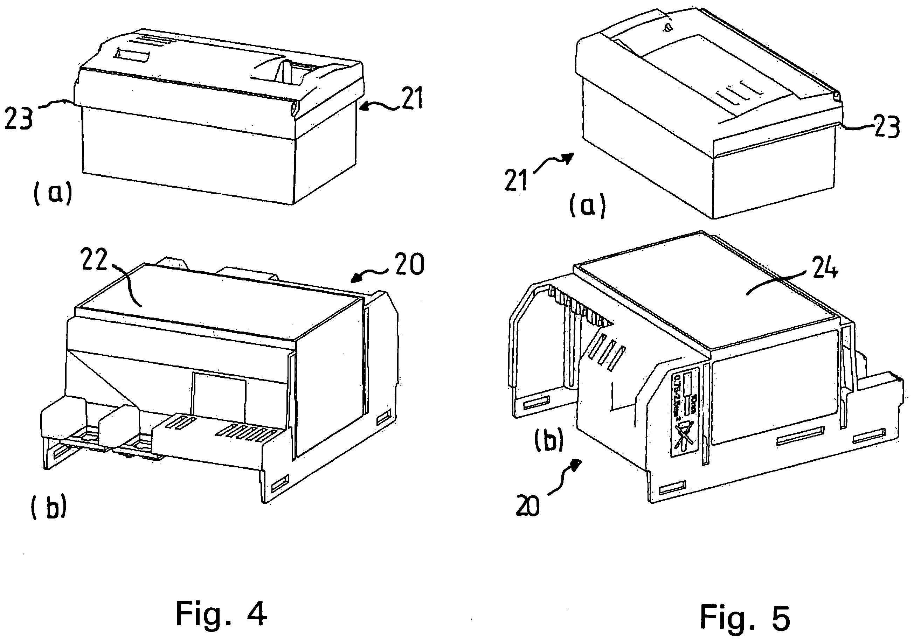

Wie insbesondere die Figuren 4 und 5 erkennen lassen, ist das Zusatzgerät 9 zweiteilig aus einem Trägermodul 20 und einem Hauptfunktionsmodul 21 aufgebaut. Der Trägermodul 20 weist bis auf den Anschluss 19 alle der oben genannten Anschlüsse auf und ist zur Verbindung des Zusatzgerätes 9 mit der Trägerschiene 7 vorbereitet. Der Hauptfunktionsmodul 21 enthält die für die Kommunikationsfunktion wesentlichen elektronischen Schaltungen.

Wie sich insbesondere aus Fig. 4 entnehmen lässt, bildet der Trägermodul 20 eine den Hauptfunktionsmodul 21 umgebende Rahmenstruktur. Für den Hauptfunktionsmodul 21 ist ein Aufnahmeschacht 22 gebildet. An dessen Innenwänden treten nicht gezeigte, mit den genannten Anschlüssen 11 bis 18 in Verbindung stehende Kontakte aus. Entsprechende, nicht gezeigte Gegenkontakte sind am Gehäuse des Hauptfunktionsmoduls 21 vorgesehen.

Das Gehäuse des Hauptfunktionsmoduls 21 weist einen flanschartigen Ansatz 23 auf, der im versenkten Zustand über den inneren Öffnungsrand des Aufnahmeschachtes 22 übersteht und bündig mit der Außenseite der Schachtwände abschließt, wie insbesondere Fig. 6 erkennen lässt.

Der Trägermodul 20 weist eine in Fig. 5 gezeigte Deckelwand 24 auf, die vor dem Einschub des Hauptfunktionsmoduls 21 in den Aufnahmeschacht 22 entfernt werden muss. In dem gezeigten Ausführungsbeispiel ist diese Deckelwand 24 mit dem Öffnungsrand des Aufnahmeschachtes 22 über eine (nicht gezeigte) Sollbruchstelle verbunden, so dass sich die Deckelwand 24 ausbrechen lässt. Alternativ käme eine Plombierung in Betracht. In jedem Fall sollte anhand einer Trennstelle oder dergleichen erkennbar sein, dass die Deckelwand 24 entfernt worden ist.

Die in Fig. 1 gezeigte Anschlussinstallation kann z.B. zusammen mit dem bereits darauf angebrachten Trägermodul 20 geliefert werden. Die Auswahl und Installation eines von mehreren unterschiedlichen, mit dem Trägermodul 20 verbindbaren Hauptfunktionsmodulen 21 kann nachträglich, insbesondere nach den Anforderungen des Nutzers, erfolgen.

An den mit der Anschlussinstallation mitgelieferten Trägermodul 20 können bereits alle innerhalb der Anschlussinstallation zu verlegenden Leitungen angeschlossen sein, insbesondere die Stromversorgungsleitungen. Die Deckelwand verhindert den Zugang zu den Kontakten im Aufnahmeschacht und damit sowohl mögliche Manipulationen des Stromzählers über diese Kontakte als auch des Abgreifens von ggf. ungezähltem Strom.

Sämtliche mit den Zusatzgeräten 9,10 verbundene Anschlussleitungen sind durch plombierbare Abdeckungen der Anschlussinstallation (nicht gezeigt) abschirmbar. Der Hauptfunktionsmodul kann in seiner eingeschobenen Stellung gesondert plombierbar oder/und eine Entriegelung durch die genannten Abdeckungen versperrt sein.

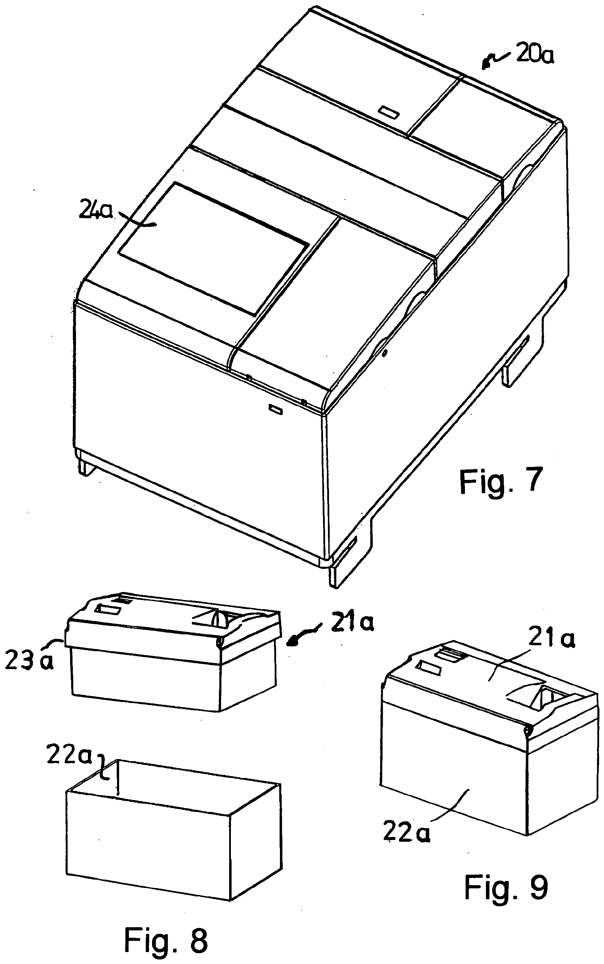

Es wird nun auf die Figuren 7 bis 9 Bezug genommen, wo gleiche oder gleichwirkende Teile mit derselben Bezugszahl wie in den vorangehenden Figuren bezeichnet sind, wobei der betreffenden Bezugszahl der Buchstabe a beigefügt ist.

Wie insbesondere die Figuren 8a und 8b erkennen lassen, ist das Kommunikationsgerät aus einem Trägermodul 20a und einem Hauptfunktionsmodul 21a aufgebaut. Der Trägermodul 20a entspricht dem Gehäuse eines Stromzählers. Der Hauptfunktionsmodul 21a enthält die für die Kommunikationsfunktionen wesentlichen elektronischen Schaltungen.

Der Trägermodul 20a bildet eines den Hauptfunktionsmodul 21a umgebende Rahmenstruktur. Für den Hauptfunktionsmodul 21a ist in dem Trägermodul 20a ein Aufnahmeschacht 21a gebildet. An dessen Innenwänden treten nicht gezeigte, mit den genannten Anschlüssen in Verbindung stehende Kontakte aus. Entsprechende, nicht gezeigte Gegenkontakte sind am Gehäuse des Hauptfunktionsmoduls 21a vorgesehen.

Das Gehäuse des Hauptfunktionsmoduls 21a weist einen flanschartigen Ansatz 23a auf, der im versenkten Zustand über den inneren Öffnungsrand des Aufnahmeschachts 22a übersteht und bündig mit der Außenseite der Schachtwände abschließt, wie insbesondere Fig. 9 erkennen lässt.

Der Trägermodul 20a weist eine in Fig. 1 gezeigte Deckelwand 24a auf, die von dem Einschub des Hauptfunktionsmoduls 21a in den Aufnahmeschacht 22a entfernt werden muss. In dem gezeigten Ausführungsbeispiel ist diese Deckelwand 24a mit dem Öffnungsrand des Aufnahmeschachts 22a über eine (nicht gezeigte) Sollbruchstelle verbunden, so dass sich die Deckelwand 24a ausbrechen lässt. Alternativ käme eine Plombierung in Betracht. In jedem Fall sollte anhand einer Trennstelle oder dergleichen erkennbar sein, dass die Deckelwand 24a entfernt worden ist.

Die Deckelwand verhindert den Zugang zu den Kontakten im Aufnahmeschacht und damit sowohl mögliche Manipulation des Stromzählers über diese Kontakte als auch des Abgreifens von ggf. ungezähltem Strom.

Sämtliche mit dem Kommunikationsgerät verbundene Anschlussleitungen sind durch plombierbare Abdeckungen der Anschlussinstallation (nicht gezeigt) abschirmbar. Der Hauptfunktionsmodul kann in seiner eingeschobenen Stellung gesondert plombierbar oder/und eine Entriegelung durch die genannten Abdeckungen versperrt sein.

## Patentansprüche

1. Zusatzgerät (9) für eine Stromzähleranschlussinstallation, das separat von einem Stromzähler an die Stromzähleranschlussinstallation anschliessbar ist, insbesondere zur Kommunikation mit dem Stromzähler, wobei das Zusatzgerät (9) Anschlüsse (11-18) für Leitungen zur Stromversorgung und SignalÜbertragung aufweist,
**dadurch gekennzeichnet,**
**dass** das Zusatzgerät (9) mehrteilig mit einem die Leitungsanschlüsse (11-18) umfassenden Trägermodul (20) und einem unter Herstellung von Verbindungen zu den Leitungsanschlüssen (11-18) mit dem Trägermodul (20) mechanisch verbindbaren Hauptfunktionsmodul (21) ausgebildet ist.

2. Zusatzgerät nach Anspruch 1,
**dadurch gekennzeichnet,**
**dass** der Trägermodul (20) eine bei Verbindung mit dem Hauptfunktionsmodul (21) zu entfernende, den Zugang zu Verbindungskontakten zu den Anschlüssen (11-18) versperrende Abdeckung (24) aufweist.

3. Zusatzgerät nach Anspruch 2,
**dadurch gekennzeichnet,**
**dass** die Abdeckung (24) nur durch Zerstörung der Abdeckung (24) selbst oder/und einer Plombierung von dem Trägermodul (20) entfernbar ist.

4. Zusatzgerät nach Anspruch 3,
**dadurch gekennzeichnet,**
**dass** eine Sollbruchstelle zum Ausbrechen der Abdeckung (24) vorgesehen ist.

5. Zusatzgerät nach einem der Ansprüche 1 bis 4,
**dadurch gekennzeichnet,**
**dass** der Trägermodul (20) den Hauptfunktionsmodul (21) in der Art einer Umrahmung umgibt.

6. Zusatzgerät nach Anspruch 5,
**dadurch gekennzeichnet,**
**dass** die Umrahmung einen Einschubschacht (22) für den Hauptfunktionsmodul (21) bildet.

7. Zusatzgerät nach Anspruch 5 oder 6,
**dadurch gekennzeichnet,**
**dass** das Gehäuse des Hauptfunktionsmoduls (21) einen den inneren Rand der Umrahmung übergreifenden Flanschansatz (23) aufweist.

8. Zusatzgerät nach einem der Ansprüche 5 bis 7,
**dadurch gekennzeichnet,**
**dass** der Hauptfunktionsmodul (21) an dem Trägermodul (20) einrastbar ist.

9. Zusatzgerät nach Anspruch 8,
**dadurch gekennzeichnet,**
**dass** der Hauptfunktionsmodul (21) in der eingerasteten Stellung plombierbar ist.

10. Zusatzgerät nach einem der Ansprüche 1 bis 9,
**dadurch gekennzeichnet,**
**dass** das Zusatzgerät über eine zum Anschluss eines Stromzählers vorgesehene Anschlusseinrichtung mit der Stromzähleranschlussinstallation verbindbar ist.

11. Zusatzgerät nach Anspruch 10,
**dadurch gekennzeichnet,**
**dass** das Zusatzgerät mit dem Stromzähler übereinstimmende Mittel zur Verbindung mit der Stromzähleranschlussinstallation über die Anschlusseinrichtung aufweist.

12. Zusatzgerät nach einem der Ansprüche 10 oder 11,
**dadurch gekennzeichnet,**
**dass** das Zusatzgerät elektrisch mit wenigstens einem zu der Anschlusseinrichtung hinführenden Phasenleiter und dem Neutralleiter verbindbar ist.

13. Zusatzgerät nach einem der Ansprüche 10 bis 12,
**dadurch gekennzeichnet,**
**dass** das Zusatzgerät zur Datenübertragung über die mit der Anschlusseinrichtung verbundenen Stromleitungen vorgesehen ist.

14. Stromzähleranschlussinstallation zur Aufnahme eines elektronischen Stromzählers und zur Befestigung als komplette Baugruppe an einem Zählerplatz eines herkömmlichen elektro-mechanischen Stromzählers, insbesondere an dessen Zählerkreuz, vorgesehen mit einem Zusatzgerät nach einem der Ansprüche 1 bis 13,

## Claims

1. Add-on device (9) for an electricity meter connection installation, which can be connected to the electricity meter add-on installation separately from an electricity meter, in particular for communicating with the electricity meter, wherein the add-on device (9) comprises terminals (11-18) for lines for supplying power and transmitting signals,
**characterised in that**
the add-on device (9) is designed in multiple parts with a support module (20) comprising the line terminals (11-18) and a main function module (21) which can be connected mechanically to the support module (20) thereby forming connections to the line terminals (11-18).

2. Add-on device according to claim 1,
**characterised in that**
the support module (20) comprises a cover (24) which is to be removed when connecting to the main functional module (21) and which blocks access to connecting contacts to the terminals (11-18).

3. Add-on device according to claim 2,
**characterised in that**
the cover (24) can only be removed from the support module (20) by destroying the cover (24) itself and/or a seal.

4. Add-on device according to claim 3,
**characterised in that**
a predetermined breaking point is provided for breaking away the cover (24).

5. Add-on device according to any of claims 1 to 4,
**characterised in that**
the support module (20) surrounds the main function module (21) in the manner of a frame.

6. Add-on device according to claim 5,
**characterised in that**
the frame forms an insertion slot (22) for the main function module (21).

7. Add-on device according to claim 5 or 6,
**characterised in that**
the housing of the main function module (21) has a flange edge (23) gripping over the inner edge of the frame.

8. Add-on device according to any of claims 5 to 7,
**characterised in that**
the main function module (21) can be locked onto the support module (20).

9. Add-on device according to claim 8,
**characterised in that**
the main function module (21) can be sealed in the locked position.

10. Add-on device according to any of claims 1 to 9,
**characterised in that**
the add-on device (9) can be connected to the electricity meter add-on installation via a connecting device provided for connecting an electricity meter.

11. Add-on device according to claim 10,
**characterised in that**
the add-on device comprises means corresponding with the electricity meter for connecting to the electricity meter connecting installation via the connecting device.

12. Add-on device according to claim 10 or 11,
**characterised in that**
the add-on device can be connected electrically to at least one phase conductor leading to the connecting device and the neutral conductor.

13. Add-on device according to any of claims 10 to 12,
**characterised in that**
the add-on device is provided for transmitting data via the power lines connected to the connecting device.

14. Electricity meter add-on installation for receiving an electronic electricity meter and for securing as a complete unit onto a meter panel of a conventional electromechanical electricity meter, in particular on its meter board, provided with an add-on device according to any of claims 1 to 13.

## Revendications

1. Appareil supplémentaire (9) pour une installation de raccordement de compteur d'électricité, qui peut être raccordé séparément d'un compteur d'électricité à l'installation de raccordement de compteur d'électricité, en particulier pour la communication avec le compteur d'électricité, lequel appareil supplémentaire (9) présente des raccordements (11-18) pour des lignes d'alimentation en courant et de transmission de signaux,
**caractérisé en ce**
**que** l'appareil supplémentaire (9) est réalisé en plusieurs parties avec un module de support (20) comprenant les raccordements de ligne (11-18) et un module fonctionnel principal (21) qui peut être raccordé mécaniquement au module de support (20) en établissant des liaisons avec les raccordements de ligne (11-18).

2. Appareil supplémentaire selon la revendication 1,
**caractérisé en ce**
**que** le module de support (20) présente un couvercle (24), à retirer lors de la liaison avec le module fonctionnel principal (21), qui bloque l'accès aux contacts de liaison avec les raccordements (11-18).

3. Appareil supplémentaire selon la revendication 2,
**caractérisé en ce**
**que** le couvercle (24) ne peut être retiré du module de support (20) qu'en détruisant le couvercle (24) lui-même et/ou un scellement.

4. Appareil supplémentaire selon la revendication 3,
**caractérisé en ce**
**qu'**une zone destinée à la rupture est prévue pour briser le couvercle (24).

5. Appareil supplémentaire selon l'une des revendications 1 à 4,
**caractérisé en ce**
**que** le module de support (20) entoure le module fonctionnel principal (21) à la manière d'un encadrement.

6. Appareil supplémentaire selon la revendication 5,
**caractérisé en ce**
**que** l'encadrement forme une fente d'insertion (22) pour le module fonctionnel principal (21).

7. Appareil supplémentaire selon la revendication 5 ou la revendication 6,
**caractérisé en ce**
**que** le boîtier du module fonctionnel principal (21) présente un rebord de bride (23) s'étendant sur le bord intérieur de l'encadrement.

8. Appareil supplémentaire selon l'une des revendications 5 à 7,
**caractérisé en ce**
**que** le module fonctionnel principal (21) peut être encliqueté sur le module de support (20).

9. Appareil supplémentaire selon la revendication 8,
**caractérisé en ce**
**que** le module fonctionnel principal (21) peut être scellé dans la position encliquetée.

10. Appareil supplémentaire selon l'une des revendications 1 à 9,
**caractérisé en ce**
**que** l'appareil supplémentaire peut être relié à l'installation de raccordement de compteur d'électricité par l'intermédiaire d'un dispositif de raccordement prévu pour le raccordement d'un compteur d'électricité.

11. Appareil supplémentaire selon la revendication 10,
**caractérisé en ce**
**que** l'appareil supplémentaire présente des moyens qui correspondent au compteur d'électricité pour la liaison à l'installation de raccordement de compteur d'électricité par l'intermédiaire du dispositif de raccordement.

12. Appareil supplémentaire selon l'une des revendications 10 ou 11,
**caractérisé en ce**
**que** l'appareil supplémentaire peut être relié électriquement à au moins un conducteur de phase menant au dispositif de raccordement et au conducteur de neutre.

13. Appareil supplémentaire selon l'une quelconque des revendications 10 à 12, **caractérisé en ce**
**que** l'appareil supplémentaire est prévu pour la transmission de données sur les lignes électriques reliées au dispositif de raccordement.

14. Installation de raccordement de compteur d'électricité destinée à recevoir un compteur d'électricité électronique et à être fixée en tant qu'ensemble complet sur un emplacement de compteur d'un compteur d'électricité électromécanique traditionnel, en particulier sur sa croix de compteur, prévue avec un appareil supplémentaire selon l'une des revendications 1 à 13.
